# EUROPEAN PATENT APPLICATION

(11) **EP 1 158 666 A1**
(43) Date of publication of application: **28.11.2001**
(21) Application number: 00304463.3
(22) Date of filing: 25.05.2000
(51) Int. Cl.: H03G 3/30

(54) **Circuit arrangement and method for discrete-time regulation of the output power of a transmission device**

(71) Applicant: LUCENT TECHNOLOGIES INC., Murray Hill, New Jersey 07974-0636 (US)
(72) Inventor: Eckl, Wolfgang Franz, 91080 Spardorf (DE)
(74) Representative: Williams, David John

(57) **Abstract**

The invention relates to a circuit arrangement (10) and to a method for discrete-time regulation of the output power of a transmission device, particularly of a base station in a mobile radio network.

Conventional power regulators have the disadvantage that, when short transient recovery times are to be achieved, large harmonics occur in the signal to be regulated.

The invention avoids these disadvantages as a result of the feature that, besides a regulator (60), a power detector (40) and at least one actuating element (30, 35), the circuit arrangement (10) has a device (70) which is connected downstream of the regulator (60) and stores a set of predetermined manipulated variables. In this arrangement, the predetermined manipulated variables map the response of the controlled system formed by the transmission device (20) and the at least one actuating element (30, 35). On the basis of the output signal from the regulator (60), the device (70) selects one of the predetermined manipulated variables and adjusts the actuating element accordingly, in order to achieve a fast approximation of the output power to a nominal value, essentially without harmonics.

## Description

The invention relates to a circuit arrangement for discrete-time regulation of the output power of a transmission device, particularly of a base station in a mobile radio network, and to a method for regulating a transmission device.

On the basis of GSM (Global System Mobile Communication) specifications, a transmitting station of a base station requires an essentially constant output signal. To this end, known power regulators are used. However, the power regulators which are currently used, for example based on a PID (Proportional, Integral, Differential) response, are not suitable for short transient recovery times, since, for this, they would have to operate at their stability limit. This results in high harmonics. Particularly when discrete-time regulation algorithms are used, regulators having short transient recovery times need to be developed.

The invention is therefore based on the object of providing a circuit arrangement and a method for discrete-time regulation of the output power of a transmission device which has short transient recovery times and, if any, only very low harmonics.

The fundamental concept of the invention should be regarded as being the use of manipulated variables, determined previously during a test phase, to achieve an optimum approximation to the nominal value as early as the first regulation step, specifically, without harmonics. In this way, the output power of the transmission device can be pulled quickly to the desired value, essentially without harmonics.

The invention solves the aforementioned technical problem, in the first instance, with the features of Claim 1.

To this end, the circuit arrangement has a power detector connected to the output of the transmission device. The feedback path of the circuit arrangement contains a regulator which has a downstream-connected device which stores a set of predetermined manipulated variables which reflect the response of the controlled system formed by the transmission device and an actuating element. On the basis of the output signal from the regulator, the device uses the stored, predetermined manipulated variables to calculate, for example by means of interpolation, a manipulated variable and supplies the latter to the actuating element for fine regulation of the output power. The manipulated variable is calculated such that a single regulation step can be used to approximate the desired output power in optimum fashion and essentially without harmonics.

The object is likewise achieved by the features of Claim 2.

To this end, the circuit arrangement again has a power detector connected to the output of the transmission device. The feedback path of the circuit arrangement contains a regulator which has a downstream-connected device which stores a set of predetermined manipulated variables which reflect the response of the controlled system formed by the transmission device and at least one actuating element. On the basis of the output signal from the regulator, the device selects a manipulated variable from the stored, predetermined manipulated variables and supplies it to the actuating element for coarse regulation of the output power. In this case, the manipulated variable is selected such that a single regulation step can be used to approximate the desired output power in virtually optimum fashion and essentially without harmonics.

To be able to achieve an optimum approximation of the output power of the transmission device to the desired output power, fine regulation of the output power is carried out at the same time as the coarse regulation. The fine regulation can take place in a plurality of steps, in which case the manipulated variable for coarse regulation is then generally no longer changed. To this end, the device is designed such that it can ascertain a manipulated variable for a further actuating element on the basis of the output signal from the regulator and of the selected predetermined manipulated variables.

To be able to compensate for changes in the attenuation and/or amplification response of the controlled system as a result of temperature fluctuations, ageing phenomena and frequency changes, the device is additionally designed for adaptive tracking or postadjustment of the predetermined manipulated variables for coarse regulation of the output power.

This device is called a nonlinear predictor below, because the response of the controlled system, i.e. the response of the actuating elements and of the transmission device (which response is reflected by the predetermined manipulated variables), is essentially identified by a nonlinear characteristic curve. The term predictor is intended to indicate that the manipulated variables for adjusting the actuating elements identify the nonlinear response of the controlled system and can thus give an indication of the output power which is established.

It is possible to use as actuating element for coarse regulation of the output power an attenuation element (which can be adjusted in 1 dB stages, for example). For fine regulation of the output power, active or passive actuating elements can be used. It is possible to use as active actuating element a voltage-controlled amplifier (VCA), which can influence both the gain factor and the attenuation factor of the controlled system. As passive element, a pin diode actuating element can be used, which can effect only one attenuation change.

The aforementioned object is also achieved by the method steps in Claim 6.

To this end, a set of manipulated variables is first ascertained and stored in the nonlinear predictor. The manipulated variables represent, in turn, the response of the controlled system formed by the transmission device and an actuating element. The manipulated variables are expediently dB values stored in table form in the nonlinear predictor with the associated, previously measured output powers of the transmission device.

In operation, the output power of the transmission device is now measured at discrete instants and compared with a nominal value to ascertain a control error. The nominal value is equivalent to a desired, constant output power. The control error is supplied to a regulator, for example a PID regulator. The regulator uses the control error preferably to produce a digital output signal which can be equivalent to a dB value. On the basis of the output signal from the regulator, the nonlinear predictor uses the stored, predetermined manipulated variables to calculate a manipulated variable which is used for fine adjustment of the actuating element, and thus for fine regulation of the output power of the transmission device. The calculation of the manipulated variable is preferably based on an interpolation algorithm.

The aforementioned object is also achieved by the method steps in Claim 7.

To this end, a set of manipulated variables is first ascertained and stored in the nonlinear predictor. The manipulated variables represent, in turn, the response of the controlled system formed by the transmission device and at least one actuating element.

In operation, the output power of the transmission device is now measured at discrete instants and compared with a nominal value to ascertain a control error. The control error is supplied to a regulator, for example a PID regulator. The regulator uses the control error preferably to produce a digital output signal. On the basis of the output signal from the regulator, the nonlinear predictor selects a manipulated variable from the stored, predetermined manipulated variables, said manipulated variable being used for coarse adjustment of the actuating element and thus for coarse regulation of the output power of the transmission device.

Fine regulation of the output power takes place at the same time as the coarse regulation of the output power. To this end, the output signal from the regulator and the associated selected manipulated variable for coarse regulation of the output power are used to ascertain a manipulated variable for a further actuating element for fine regulation of the output power.

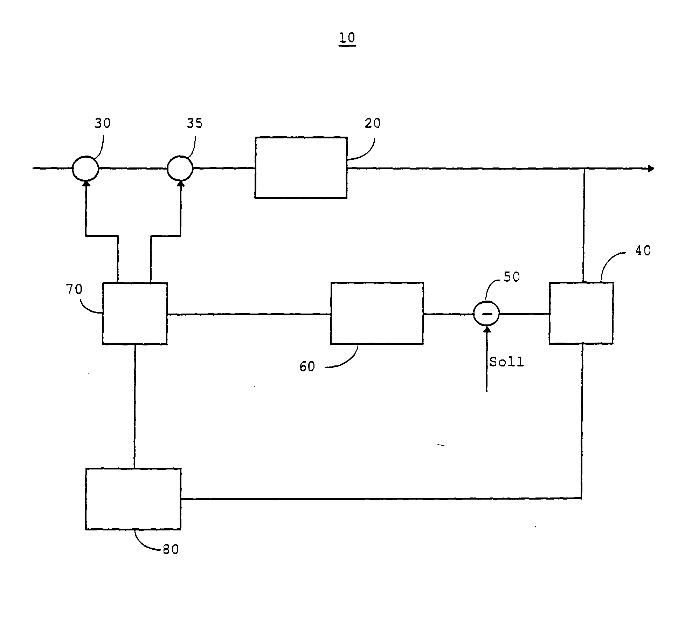

The invention is explained in more detail below with the aid of an illustrative embodiment in conjunction with the attached figure.

The figure shows a schematic block diagram of a circuit arrangement 10 for discrete-time regulation of the output power of a transmission device 20. At the input, two actuating elements 30 and 35 are connected upstream of the transmission device 20. The actuating element 30 is an attenuation element 30, for example, which is adjustable in 1 dB stages, for example. As explained further below, the attenuation element 30 is used for coarse regulation of the output power of the transmission device 20. The actuating element 35 can be a voltage-controlled amplifier, which is used for fine regulation of the output power of the transmission device 20. The output signal from the transmission device 20 is supplied to a power detector 40 arranged in the feedback path of the circuit arrangement 10. The output signal from the power detector 40 is supplied to a subtracter 50, to whose second input the nominal variable, which corresponds to the desired output power, is applied. The output signal from the subtracter 50, which corresponds to the control error, is supplied to a PID regulator in the present example. To this extent, the circuit arrangement 10 is equivalent to conventional regulators. To attain a short transient recovery time essentially without harmonics in the output signal from the transmission device 20, the PID regulator 60 has a downstream-connected nonlinear predictor 70 which is connected both to the attenuation element 30 and to the voltage-controlled amplifier 35. As explained in more detail below, the nonlinear predictor 70 is used to describe the usually nonlinear response of the controlled system essentially formed by the actuating elements 30 and 35 and the transmission device 20. To this end, the predictor 70 stores a value table containing a set of predetermined manipulated variables for the attenuation element 30 and the associated measured output powers of the transmission device 20. The stored manipulated variables and output powers are ascertained as follows:
1. A test path is first set up comprising only the actuating elements 30 and 35, the transmission device 20 and the power detector 40.
2. A predetermined transmission power is then applied to the input of the test path, and the output power of the transmission device 20 is ascertained for all manipulated variables applied to the attenuation element 30. Each measured output power therefore has a particular manipulated variable associated with it.
3. Each measured output power and each associated manipulated variable is stored in the nonlinear predictor 70.

As the figure shows, the nonlinear predictor 70 has an associated adaptation device 80 which is connected to an output of the power detector 40. The adaptation device 80 can be used to compensate for temperature-related, age-related and frequency-related fluctuations in the controlled system by changing the stored manipulated variables as appropriate.

The way in which the circuit arrangement 10 operates is explained in more detail below.

It is first assumed that the input of the circuit arrangement has, by way of example, a GSM signal applied to it which is intended to be transmitted in particular time slots. The GSM signal has, at predetermined instants, a respective test sequence with a constant power level, which is used as a reference level for the circuit arrangement 10. Whenever the so-called test sequence with a constant power level occurs, this output power is ascertained by means of the power detector 40. The subtracter 50 now uses the measured output power and the nominal variable to ascertain a control error, which is converted in the PID regulator 60 to form a corresponding numerical value, for example 45.2 dB. In the nonlinear predictor 70, the numerical value output by the PID regulator 60 is compared with the stored manipulated variables, likewise numerical values in the unit dB. By way of example, the manipulated variable closest to the output numerical value, i.e. 45 dB, is selected and supplied to the attenuation element 30 for coarse regulation of the output power. At the same time, the nonlinear predictor 70 uses the selected manipulated variable and the numerical value output by the PID regulator 60 to calculate the difference, in the present example 0.2 dB, used as manipulated variable for the voltage-controlled amplifier 35 for the purpose of fine regulation of the output power. The predictor 70 allows the two actuating elements 30 and 35 to be adjusted using precise manipulated variables such that, as early as the first regulation step, an optimum approximation of the output power of the transmission device 20 to the nominal variable is achieved essentially without harmonics in the output power. This is because, using the stored manipulated variables, the predictor 70 can make a precise prediction about the output power of the transmission device which is established at a particular input power.

Owing to various factors, such as temperature fluctuations and ageing of the components, the nonlinear characteristic curves of the actuating elements 30 and 35 and of the transmission device 20 can vary, so that postadjustment of the manipulated variables stored in the nonlinear predictor 70 would be advantageous. To this end, the adaptation device 80, which can be a component part of the nonlinear predictor, checks, in each regulation step, whether and by what value the manipulated variable instantaneously being used needs to be matched to the new circumstances.

At this point, it should be mentioned that the nonlinear predictor 70, the adaptation device 80, the PID regulator 60 and the subtracter 50 are preferably implemented in microprocessor form.

## Claims

1. Circuit arrangement for discrete-time regulation of the output power of a transmission device (20), particularly a base station in a mobile radio network, having
a power detector (40) which is connected to the output of the transmission device (20),
a regulator (60), and
an actuating element,
**characterized by**
a device (70) which is connected downstream of the regulator (60) and stores a set of predetermined manipulated variables which reflect the response of the controlled system formed by the transmission device (20) and the actuating element, and in which the device (70), on the basis of the output signal from the regulator (60), uses the predetermined manipulated variables to calculate a manipulated variable for adjusting the actuating element, and outputs said manipulated variable to the latter.

2. Circuit arrangement for discrete-time regulation of the output power of a transmission device (20), particularly a base station in a mobile radio network, having
a power detector (40) connected to the output of the transmission device (20),
a regulator (60), and
at least one actuating element (30, 35),
**characterized by**
a device (70) which is connected downstream of the regulator (60) and stores a set of predetermined manipulated variables which reflect the response of the controlled system formed by the transmission device (20) and the at least one actuating element (30, 35), and in which the device (70), on the basis of the output signal from the regulator, outputs one of the predetermined manipulated variables to adjust the at least one actuating element.

3. Circuit arrangement according to Claim 2,
**characterized in that**
the set of predetermined manipulated variables which is stored in the device (70) is used for coarse regulation of the output power, and **in that**
the device (70) is designed to determine a manipulated variable for a further actuating element (35) for fine regulation of the output power on the basis of the output signal from the regulator (60) and the associated predetermined manipulated variables.

4. Circuit arrangement according to Claim 2 or 3,
**characterized in that**
the device (70) is designed for adaptive tracking the predetermined manipulated variables.

5. The circuit arrangement as claimed in one of Claims 2 to 4,
**characterized in that**
the at least one actuating element (30) is an attenuation element for coarse regulation, and the further actuating element (35) is an active or passive element for fine regulation of the output power.

6. Method for discrete-time regulation of the output power of a transmission device, particularly of a base station in a mobile radio network, having the following method steps:
a set of manipulated variables which reflect the response of the controlled system formed by the transmission device (20) and an actuating element is ascertained and stored;
the output power of the transmission device is detected at discrete instants;
a control error between the detected output power and a nominal value is ascertained;
the control error is supplied to a regulator (60);
a manipulated variable is calculated from the stored, predetermined manipulated variables for the actuating element on the basis of the output signal from the regulator (60); and
the manipulated variable calculated is supplied to the actuating element.

7. Method for discrete-time regulation of the output power of a transmission device, particularly of a base station in a mobile radio network, having the following method steps:
a set of manipulated variables which reflect the response of the controlled system formed by the transmission device (20) and at least one actuating element (30, 35) is ascertained and stored;
the output power of the transmission device (20) is detected at discrete instants;
a control error between the detected output power and a nominal value is ascertained;
the control error is supplied to a regulator (60);
one of the stored, predetermined manipulated variables is selected on the basis of the output signal from the regulator; and
the selected predetermined manipulated variable is supplied to the at least one actuating element (30) for coarse regulation of the output power.

8. Method according to Claim 7,
**characterized in that**
the output signal from the regulator and the predetermined manipulated variable, selected in this respect, for coarse regulation of the output power are used to ascertain a manipulated variable for a further actuating element (35) for fine regulation of the output power.

9. Method according to Claim 7 or 8,
**characterized in that**
the predetermined manipulated variables for coarse regulation of the output power are adaptively tracked.
